# EUROPEAN PATENT SPECIFICATION

(11) **EP 1 849 340 B1**
(45) Date of publication and mention of the grant of the patent: **17.09.2008**
(21) Application number: 06717453.2
(22) Date of filing: 05.01.2006
(51) Int. Cl.: H05K 9/00

(54) **FLAME RETARDANT EMI SHIELDING GASKET**
FLAMMWIDRIGE EMI-ABSCHIRMDICHTUNG
JOINT DE BLINDAGE EMI IGNIFUGE

(30) Priority: 16.02.2005 US 653395 P
(43) Date of publication of application: 31.10.2007
(73) Proprietor: PARKER-HANNIFIN CORPORATION, Cleveland, Ohio 44124-4141 (US)
(72) Inventor: CLOUTIER, Bryan R., Londonderry, New Hampshire 03053 (US); FLANDERS, William I., Merimack, New Hampshire 03054 (US); THORNTON, Steven L., Windham, New Hampshire 03087 (US); LIONETTA, William G., Winchester, Massachusetts 01890 (US)
(74) Representative: Albutt, Anthony John
(86) International application number: PCT/US2006/000252
(87) International publication number: WO 2006/088565

(56) References cited:
- EP-A2- 0 403 112
- JP-A- 11 004 094
- JP-A- 2003 243 873
- US-A1- 2002 125 026
- US-A1- 2003 124 934
- US-A1- 2004 142 616

## Description

### BACKGROUND OF THE INVENTION

The present invention relates broadly to gaskets for providing electromagnetic interference (EMI) shielding and weather, dust, or other environmental sealing, and particularly to a combination or composite gasket construction and method of its manufacture combining a metal mesh strip gasket with an integral solid or foam elastomeric weather-sealing strip which is especially adapted for use within cabinets and other enclosures for electrical or electronic systems or devices.

The operation of electronic devices such as televisions, radios, computers, medical instruments, business machines, communications equipment, and the like is attended by the generation of electromagnetic radiation within the electronic circuitry of the equipment. As is detailed in U.S. Patent Nos. 5,202,536; 5,142,101; 5,105,056; 5,028,739; 4,952,448; and 4,857,668, such radiation often develops as a field or as transients within the radio frequency band of the electromagnetic spectrum, i.e., between about 10 KHz and 10 GHz, and is termed "electromagnetic interference" or "EMI" as being known to interfere with the operation of other proximate electronic devices.

To attenuate EMI effects, shielding having the capability of absorbing and/or reflecting EMI energy may be employed both to confine the EMI energy within a source device, and to insulate that device or other "target" devices from other source devices. Such shielding is provided as a barrier which is inserted between the source and the other devices, and typically is configured as an electrically conductive and grounded housing which encloses the device. As the circuitry of the device generally must remain accessible for servicing or the like, most housings are provided with openable or removable accesses such as doors, hatches, panels, or covers. Between even the flattest of these accesses and its corresponding mating or faying surface, however, there may be present gaps which reduce the efficiency of the shielding by presenting openings through which radiant energy may leak or otherwise pass into or out of the device. Moreover, such gaps represent discontinuities in the surface and ground conductivity of the housing or other shielding, and may even generate a secondary source of EMI radiation by functioning as a form of slot antenna. In this regard, bulk or surface currents induced within the housing develop voltage gradients across any interface gaps in the shielding, which gaps thereby function as antennas which radiate EMI noise. In general, the amplitude of the noise is proportional to the gap length, with the width of the gap having less appreciable effect.

For filling gaps within mating surfaces of housings and other EMI shielding structures, gaskets and other seals have been proposed both for maintaining electrical continuity across the structure, and for excluding from the interior of the device such contaminates as moisture and dust. Such seals are bonded or mechanically attached to, or press-fit into, one of the mating surfaces, and function to close any interface gaps to establish a continuous conductive path thereacross by conforming under an applied pressure to irregularities between the surfaces. Accordingly, seals intended for EMI shielding applications are specified to be of a construction which not only provides electrical surface conductivity even while under compression, but which also has a resiliency allowing the seals to conform to the size of the gap. The seals additionally must be wear resistant, economical to manufacture, and capability of withstanding repeated compression and relaxation cycles. EMI shielding gaskets and other electrically-conductive materials, their methods of manufacture, and their use are further described in U.S. Patent Nos. 6,121,545; 6,096,413; 6,075,205; 5,996,220; 5,910,524; 5,902,956; 5,902,438; 5,882,729; 5,804,762; 5,731,541; 5,641,438; 5,603,514; 5,584,983; 5,578,790; 5,566,055; 5,524,908; 5,522,602; 5,512,709; 5,438,423; 5,294,270; 5,202,536; 5,142,101; 5,141,770; 5,136,359; 5,115,104; 5,107,070; 5,105,056; 5,068,493; 5,054,635; 5,049,085; 5,028,739; 5,008,485; 4,988,550; 4,979,280; 4,968,854; 4,952,448; 4,931,479; 4,931,326; 4,871,477; 4,864,076; 4,857,668; 4,800,126; 4,529,257; 4,441,726; 4,301,040; 4,231,901; 4,065,138; 3,758,123; 3,026,367; 2,974,183; and 2,755,079, in U.S. Patent Appln. Publ. No. 20020010223, International (PCT) Patent Appln. Nos. WO 01/71223; 01/54467; 00/23,513; 99/44,406; 98/54942; 96/22672; and 93/23226, Japanese Patent Publication (Kokai) No. 7177/1993, European Pat. Appln. No. 1,094,257, German Patent No. 19728839, and Canadian Patent No. 903,020, in Severinsen, J., "Gaskets That Block EMI," Machine Design, Vol. 47, No. 19, pp. 74-77 (August 7, 1975), and in the following publications of the Chomerics Division of Parker Hannifin Corporation, Wobum, MA: "SOFT-SHIELD® 1000 Series;" "SOFT-SHIELD® 2000 Series;" "SOFT-SHIELD® 4000 Series;" "SOFT-SHIELD® 5000 Series;" and "SOFT-SHIELD® 5500, Preliminary Product Data Sheet (1998) Series; "COMBO® STRIP Gaskets;" "SPRINGMESH^{™} Highly Resilient EMI Mesh Gasket," Technical Bulletin 114; "METAL STRIP® All Metal Gaskets;" "SHIELDMESH^{™} Compressed Mesh Gaskets;" and "METALKLIP® Clip-On EMI Gasket."

EMI shielding gaskets typically are constructed as a resilient element, or a combination of one or more resilient elements having gap-filling capabilities. One or more of the elements may be provided as a tubular or solid, foamed or unfoamed core or strip which is filled, sheathed, or coated to be electrically-conductive, or otherwise which is formed of an inherently conductive material such as a metal wire spring mesh. One or more of the other elements, and particularly in the case of a composite or "combination gasket" having a conductive EMI shielding element in combination with an integral weather sealing strip (such as is sold commercially by the Chomerics Division of Parker-Hannifin Corporation (Woburn, MA) under the name "COMBO® STRIP Gasket"), may be formed of a sheet, strip, "picture-frame," or other open or closed geometry of a solid, i.e., unfoamed, or foamed elastomeric material providing enhanced environmental sealing capabilities to which the conductive element is adhesively-bonded or otherwise joined. Each of the core or strip of the conductive element and the elastomeric material of the environmental sealing element may be formed of an elastomeric thermoplastic material such as polyethylene, polypropylene, or polyvinyl chloride, a thermoplastic or thermosetting rubber such as a butadiene, styrene-butadiene, nitrile, chlorosulfonate, neoprene, urethane, or silicone, or a blend such as polypropylene-EPDM. Conductive materials for the filler, sheathing, or coating of the conductive element include metal or metal-plated particles, fabrics, meshes, and fibers. Preferred metals include copper, nickel, silver, aluminum, tin or an alloy such as Monel, with preferred fibers and fabrics including natural or synthetic fibers such as cotton, wool, silk, cellulose, polyester, polyamide, nylon, polyimide. Alternatively, other conductive particles and fibers such as carbon, graphite, or a conductive polymer material may be substituted.

Conventional manufacturing processes for EMI shielding gaskets include extrusion, molding, die-cutting, and form-in-place (FIP). In this regard, die-cutting involves the forming of the gasket from a cured sheet of an electrically-conductive elastomer which is cut or stamped using a die or the like into the desired configuration. Molding, in turn, involves the compression or injection molding of an uncured or thermoplastic elastomer into the desired configuration. FIP, as described in commonly-assigned U.S. Patent Nos. 6,096,413; 5,910,524; 5,641,438; 4,931,479, and International (PCT) Patent Appln. No. 96/22672; and in U.S. Patent Nos. 5,882,729 and 5,731,541, International (PCT) Patent Appln. No. WO 01/71223, and Japanese Patent Publication (Kokai) No. 7177/1993, involves the application of a bead of a viscous, curable, electrically-conductive composition which is dispensed in a fluent state from a nozzle directly onto to a surface of a substrate such as a housing or other enclosure. The composition, typically a silver-filled or otherwise electrically-conductive silicone or polyurethane foamed or unfoamed elastomer, then is foamed and/or cured-in-place via a chemical, thermal, or physical reaction which may be initiated or catalyzed via the application of heat or with atmospheric moisture or ultraviolet (UV) radiation to form an electrically-conductive, elastomeric EMI shielding gasket profile in situ on the substrate surface.

Requirements for typical EMI shielding applications often dictate a low impedance, low profile gasket which is deflectable under normal closure force loads. Other requirements include low cost and a design which provides an EMI shielding effectiveness for both the proper operation of the device and compliance, in the United States, with commercial Federal Communication Commission (FCC) EMC regulations.

Particularly economical gasket constructions, which also requires very low closure forces, i.e. less than about 1 lb/inch (0.175 N/mm), is marketed by the Chomerics Division of Parker-Hannifin Corp., Woburn, MA under the tradenames "Soft-Shield® 5000 Series" and "Soft-Shield® 3500 Series." Such constructions consist of an electrically-conductive jacket or sheathing which is "cigarette" wrapped lengthwise over a polyurethane or other foam core. As is described further in U.S. Patent No. 4,871,477, polyurethane foams generally are produced by the reaction of polyisocyanate and a hydroxyl-functional polyol in the presence of a blowing agent. The blowing agent effects the expansion of the polymer structure into a multiplicity of open or closed cells.

The jacket is provided as a highly conductive, i.e., about 1 Ω-sq., nickel-plated-silver, woven rip-stop nylon which is self-terminating when cut. Advantageously, the jacket may be bonded to the core in a continuous molding process wherein the foam is blown or expanded within the jacket as the jacket is wrapped around the expanding foam and the foam and jacket are passed through a die and into a traveling molding. Similar gasket constructions are shown in commonly-assigned U.S. Patent No. 5,028,739 and in U.S. Patent Nos. 4,857,668; 5,054,635; 5,105,056; and 5,202,536.

Many electronic devices, including PC's and communication equipment, must not only comply with certain FCC requirements, but also must meet be approved under certain Underwriter's Laboratories (UL) standards for flame retardancy. In this regard, if each of the individual components within an electronic device is UL approved, then the device itself does not require separate approval. Ensuring UL approval for each component therefore reduces the cost of compliance for the manufacturer, and ultimately may result in cheaper goods for the consumer. For EMI shielding gaskets, however, such gaskets must be made flame retardant, i.e., achieving a rating of V-0 under UL Std. No. 94, "Tests for Flammability of Plastic Materials for Parts in Devices and Appliances" (1991), without compromising the electrical conductivity necessary for meeting EMI shielding requirements.

In this regard, and particularly with respect to EMI shielding gaskets of the above-described fabric over foam variety, it has long been recognized that foamed polymeric materials are flammable and, in certain circumstances, may present a fire hazard. Owing to their cellular structure, high organic content, and surface area, most foam materials are subject to relatively rapid decomposition upon exposure to fire or high temperatures.

One approach for imparting flame retardancy to fabric over foam gaskets has been to employ the sheathing as a flame resistant protective layer for the foam. Indeed, V-0 rating compliance purportedly has been achieved by sheathing the foam within an electrically-conductive Ni/Cu-plated fabric to which a thermoplastic sheet is hot nipped or otherwise fusion bonding to the underside thereof. Such fabrics, which may be further described in one or more of U.S. Patent Nos. 4,489,126; 4,531,994; 4,608,104; and/or 4,621,013, have been marketed by Monsanto Co., St. Louis, under the tradename "Flectron® Ni/Cu Polyester Taffeta V0."

Other fabric over foam gaskets, as is detailed in U.S. Patent No. 4,857,668, incorporate a supplemental layer or coating applied to the interior surface of the sheath. Such coating may be a flame-retardant urethane formulation which also promotes the adhesion of the sheath to the foam. The coating additionally may function to reduce bleeding of the foam through the fabric which otherwise could compromise the electrical conductivity of the sheath..

Electrically-conductive, flame retardant materials for use in fabric-over-foam EMI shielding gaskets, and methods of manufacturing the same, also have been described in commonly-assigned U.S. Patent Nos. 6,777,095; 6,716,536; 6,521,348; 6,387,523; and 6,248,393. Such materials, in having a layer of a flame retardant coating applied to one side of an electrically-conductive, generally porous fabric, afford UL94 V-0 protection when used as a jacketing in a fabric-over-foam gasket construction.

Due to recent regulatory changes in Europe and elsewhere, certain flame retardant compounds, including many bromine compounds, face increased restrictions as to their use within electronic devices. Accordingly, it is believed that further improvements in the design of flame retardant, fabric-over foam EMI shielding gaskets, as well as sheathing materials therefore, would be well-received by the electronics industry. Especially desired would be a flame retardant gasket construction which achieves a UL94 rating of V-0 and also meets the stricter regulatory requirements such as European Union Directive 2002/95/EC, "Restriction on the Use of Certain Hazardous Substances (RoHS) in Electrical and Electronic Equipment."

### BROAD STATEMENT OF THE INVENTION

The present invention is directed to electrically-conductive, flame retardant materials, and more particularly to fabric-over-foam EMI shielding gaskets constructed of such materials. In employing a layer of a flame retardant, thermosetting polyester or other such film adhesive which may be nipped or otherwise applied to one side of an electrically-conductive fabric, the material of the invention affords UL94 V-0 protection when used a sheath or jacket in fabric-over-foam gasket constructions.

Such film adhesive layer may be hot nipped or otherwise applied to one side of the fabric without compromising the electrical surface conductivity of the other side of the fabric. Such layer, moreover, is RoHS compliant and maintains the drapability the fabric and facilitating the construction of gaskets having complex profiles and/or narrow cross-sections.

As used within fabric-over-foam gasket constructions, the material of the invention may be wound, wrapped, or otherwise provided as a sheath or jacket surrounding a foam center or core with the side to which the film adhesive layer has been applied being disposed as an interior surface adjacent the foam, and the uncoated side being disposed as an electrically-conductive exterior surface. Advantageously, the thermosetting polyester film adhesive layer on the interior surface of the jacket may be used to bond the jacket to the foam core. In use, such layer has been observed to hold seams of the fabric more securely to the foam core to thereby resist a common failure mode in flame testing, namely, the opening of those seams and the direct exposure of the foam to the flame.

The present invention, accordingly, comprises the materials, gaskets, and/or methods possessing the construction, combination of elements, and/or arrangement of parts and steps which are exemplified in the detailed disclosure to follow. Advantages of the present invention include a flame retardant yet drapable EMI shielding fabric. Additional advantages include an economical, flame retardant EMI shielding gasket construction wherein a relatively thin layer of a thermosetting polyester or other such film adhesive affording both RoHS compliance and UL94 V-0 protection in the final gasket construction may be hot nipped or otherwise applied to one side of an electrically-conductive, woven or other EMI shielding fabric without compromising the conductivity of the other side of the fabric. These and other advantages will be readily apparent to those skilled in the art based upon the disclosure contained herein.

### BRIEF DESCRIPTION OF THE DRAWING

For a fuller understanding of the nature and objects of the invention, reference should be had to the following detailed description taken in connection with the accompanying drawing wherein:
Fig. 1 is a perspective end view of a length of a representative fabric-over-foam EMI shielding gasket construction according to the present invention; and
Fig. 2 is magnified view of a portion of the end of the gasket of Fig. 1.

The drawings will be described further in connection with the following Detailed Description of the Invention.

### DETAILED DESCRIPTION OF THE INVENTION

Certain terminology may be employed in the description to follow for convenience rather than for any limiting purpose. For example, the terms "forward," "rearward," "right," "left," "upper," and "lower" designate directions in the drawings to which reference is made, with the terms "inward," "interior," "inner," or "inboard" and "outward," "exterior," "outer," or "outboard" referring, respectively, to directions toward and away from the center of the referenced element, and the terms "radial" or "horizontal" and "axial" or "vertical" referring, respectively, to directions, axes, planes perpendicular and parallel to the central longitudinal axis of the referenced element. Terminology of similar import other than the words specifically mentioned above likewise is to be considered as being used for purposes of convenience rather than in any limiting sense. Further, the term "EMI shielding" should be understood to include, and to be used interchangeably with, electromagnetic compatibility (EMC), electrical conduction and/or grounding, corona shielding, radio frequency interference (RFI) shielding, and anti-static, i.e., electro-static discharge (ESD) protection. The terms "flame retardant" and "fire retardant" also may be used interchangeably.

In the figures, elements having an alphanumeric designation may be referenced herein collectively or in the alternative, as will be apparent from context, by the numeric portion of the designation only. Further, the constituent parts of various elements in the figures may be designated with separate reference numerals which shall be understood to refer to that constituent part of the element and not the element as a whole. General references, along with references to spaces, surfaces, dimensions, and extents, may be designated with arrows.

For the illustrative purposes of the discourse to follow, the electromagnetic interference (EMI) shielding material herein involved is described in connection with its use as a flame retardant, electrically-conductive jacket for a foam core, EMI shielding gasket as may be adapted to be received within an interface, such as between a door, panel, hatch, cover, or other parting line of an electromagnetic interference (EMI) shielding structure. The EMI shielding structure may be the conductive housing of a computer, communications equipment, or other electronic device or equipment which generates EMI radiation or is susceptible to the effects thereof. The gasket may be bonded or fastened to, or press-fit into one of a pair of mating surfaces which define the interface within the housing, and functions between the mating surfaces to seal any interface gaps or other irregularities. That is, while under an applied pressure, the gasket resiliently conforms to any such irregularities both to establish a continuous conductive path across the interface, and to environmentally seal the interior of the housing against the ingress of dust, moisture, or other contaminates.

In view of the discourse to follow, however, it will be appreciated that aspects of the present invention may find utility in other applications requiring a resilient, electrically conductive seal, gasket, fencing, or other connection, screen, or shield for EMI shielding or other purposes. Use within those such other applications therefore should be considered to be expressly within the scope of the present invention.

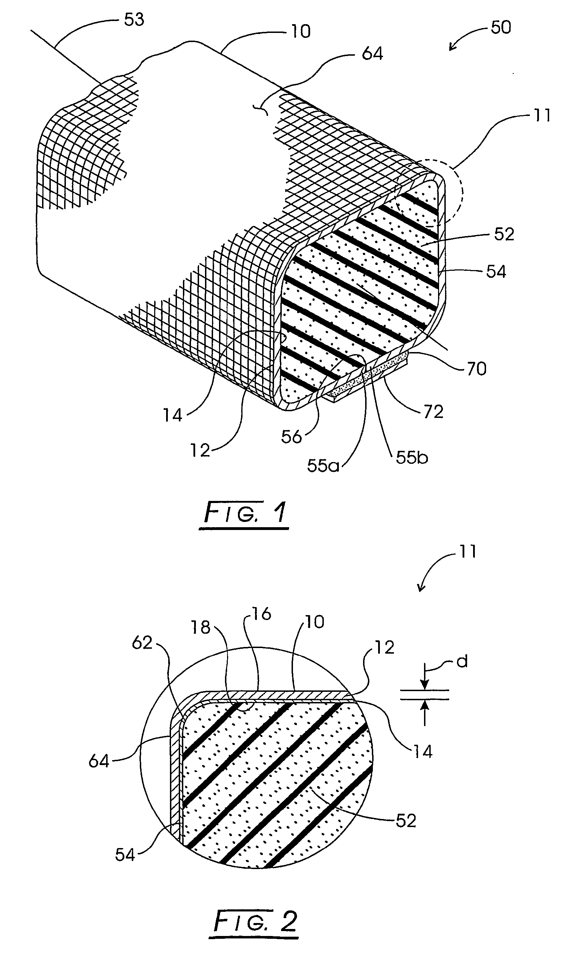

Referring then to the figures wherein corresponding reference characters are used to designate corresponding elements throughout the several views with equivalent elements being referenced with prime or sequential alphanumeric designations, a flame retardant EMI shielding material according to the present invention is shown generally at 10 in Fig. 1 as used as a jacket within the fabric-over-foam gasket construction which is referenced generally at 50. As supplied for the gasket 50, material 10 may be provided on a roll or the like and then cut to size. In basic construction, and as may be seen best with momentary reference of the portion of Fig. 1 referenced at 11 which is represented as the magnified view of Fig. 2, material 10 includes an outer fabric member, 12, and an inner layer, 14, of a cured, thermoset, flame retardant film adhesive.

With continuing reference to Fig. 2, fabric member 12 has an electrically-conductive exterior surface, 16, and a conductive or non-conductive interior surface, 18, defining a thickness dimension, referenced at "d," therebetween which may vary from about 2-4 mils (50.8-101.6 µm). By "electrically-conductive," it is meant that the fabric may be rendered conductive, i.e., to a surface resistivity of about 0.1 Ω/sq. or less, by reason of its being constructed of electrically-conductive wire, monofilaments, yarns or other fibers or, alternatively, by reason of a treatment such as a plating or sputtering being applied to non-conductive fibers to provide an electrically-conductive layer thereon. Preferred electrically-conductive fibers include Monel nickel-copper alloy, silver-plated copper, nickel-clad copper, Ferrex® tin-plated copper-clad steel, aluminum, tin-clad copper, phosphor bronze, carbon, graphite, and conductive polymers. Preferred non-conductive fibers include cotton, wool, silk, cellulose, polyester, polyamide, nylon, and polyimide monofilaments or yarns which are rendered electrically conductive with a metal plating of copper, nickel, silver, nickel-plated-silver, aluminum, tin, or an alloy thereof. As is known, the metal plating may applied to individual fiber strands or to the surfaces of the fabric after weaving, knitting, or other fabrication.

While fabrics such as wire meshes, knits, and non-woven cloths and webs may find application, a typical fabric construction for member 12 is a woven nylon or polyester cloth which is made electrically conductive with between about 20-40% by weight based on the total fabric weight, i.e., 0.01-0.10 g/in², of a silver, nickel-silver, or silver-nickel over copper plating. Although a plain, square weave pattern such as a taffeta, tabby, or ripstop may be suited for many applications, other weaves such as satins, twills, and the like also should be considered within the scope of the invention herein involved. A particularly suited cloth for fabric member 12 is a 4 mil (0.10 mm) thick, 1.8 oz/yd² weight, silver-plated, woven nylon which is marketed commercially under the designation "31EN RIPSTOP" by Swift Textile Metalizing Corp., Bloomfield, CT. However, depending upon the needs of the specific shielding application, a fabric constructed of a combination or blend of conductive and nonconductive fibers alternatively may be employed. Examples of fabrics woven, braided, or warp knitted from electrically-conductive fibers, or from blends of conductive and non-conductive fibers, are described in Gladfelter, U.S. Patent No. 4,684,762, and in Buonanno, U.S. Patent No. 4,857,668.

Layer 14 may be formed of a flame retardant film adhesive which may be hot nipped or otherwise applied to the interior surface 18 of fabric member 12. Preferably, the temperature and/or pressure under which a curable film of the adhesive layer may be applied to the fabric member 12 is controlled so as to delimit the penetration of the layer 14 to a depth which is less than the thickness dimension of the fabric member 12. In this regard, when the layer thereafter is cured on the interior surface 18 of fabric member 12, the exterior surface 16 thereof may be made to remain electrically-conductive. In an illustrative construction, the layer 14, which may be provided as having a thickness of between about 1-10 mils (25.4-254 µm), may be hot nipped onto the interior surface 18 of the fabric member 12 at a temperature of between about 200-250°F (93-121 °C).

The curable film adhesive forming the layer 14 may be formulated as a comprising a curable, thermosetting resin which may be, for example, a polyester or copolyester resin, or, alternatively another thermosetting resin such as a phenoxy urethane or a nitrile phenolic. Flame retardancy may be imparted by filling the resin with an effective amount, typically between about 10-90% by total weight, of one or more conventional flame retardant additives such as aluminum hydrate or other aluminum compounds, antimony trioxide or other antimony compounds, phosphate esters, or halogenated compounds such as polybrominated diphenyl oxides. In service, should the gasket 50 be ignited, the decomposition of the flame retardant additives function to chemically deprive the flame of sufficient oxygen to support combustion. The decomposition of the resin phase additionally may lead to the development of a protective, i.e., thermally-insulative or refractory, outer char layer. A suitable polyester-based flame retardant film adhesive which is RoHS compliant is marketed commercially by Bostik, Inc., Middleton, MA, under the designation "340 Film Series" adhesive.

As mentioned, EMI shielding material 10 of the present invention is particularly adapted for use as a flame retardant, electrically-conductive jacket which is provided over a foam core in an EMI shielding gasket construction. Returning now to Fig. 1, in a representative embodiment, gasket 50 includes an elongate, resilient foam core member, 52, which may be of an indefinite length along a longitudinal axis, 53. Core member 52 has an outer circumferential surface, 54, defining the cross-sectional profile of gasket 50 which, for illustrative purposes, is of a generally polygonal, i.e., square or rectangular geometry. Other plane profiles, such as circular, semi-circular, or elliptical, or complex profiles may be substituted, however, depending upon the geometry of the interface to be sealed. Core member 12 may be of any radial or diametric extent, but for most applications will have a diametric extent or width of from about 0.25 inch (0.64 cm) to 1 inch (2.54 cm).

For affording gap-filling capabilities, it is preferred that core member 52 is provided to be complaint over a wide range of temperatures, and to exhibit good compression-relaxation hysteresis even after repeated cyclings or long compressive dwells. Core member 52 therefore may be formed of a foamed elastomeric thermoplastic such as a polyethylene, polypropylene, polypropylene-EPDM blend, butadiene, styrene-butadiene, nitrile, chlorosulfonate, or a foamed neoprene, urethane, or silicone. Preferred materials of construction include open or closed cell urethanes or blends such as a polyolefin resin/monoolefin copolymer blend, or a neoprene, silicone, or nitrile sponge rubber.

Core member 52 may be provided as an extruded or molded foam profile over which a tape or sheet of shielding material 10 may be "cigarette" or otherwise wrapped or wound as a sheath, with the opposing edges, referenced at 55a-b, being adjoined as shown, or, alternatively, overlapped, so as to form a seam, 56, which, depending upon how the material 10 is wrapped, may extend generally linearly, helically, or otherwise along the lengthwise extent of the gasket 10. As may be seen best in Fig. 2, in such construction of the gasket 50 material 10 is wrapped such that the curable film adhesive layer 14 is disposed adjacent the outer surface 54 core 52 as an interior surface, 62, of the shielding member 10, with the uncoated side 16 of fabric 12 being oppositely disposed as an electrically-conductive exterior surface, 64, of the gasket 50. As the material 10 is being so applied to the core 52, the material 10 may be heated to a temperature of between about 200-250°F (93-121°C) for a few seconds. Thereafter, the layer 14 may be cross-linked, i.e., vulcanized, or otherwise cured by heating the gasket 50 to a temperature of between about 300-350°F (149-177°C) for between about a minute or less or up to about 5 minutes, depending on temperature. As so cured, the layer 14 bonds the fabric 12 and, particularly, the edges 55 forming the seam 56 thereof, to the core 52.

Referring again to Fig. 1, an adhesive layer, 70, may be applied along the lengthwise extent of gasket 50 to the underside of exterior surface 64 for the attachment of the gasket to a substrate. Such layer 70 preferably is formulated to be of a pressure sensitive adhesive (PSA) variety. As is described in U.S. Patent No. 4,988,550, suitable PSA's for EMI shielding applications include formulations based on silicones, neoprene, styrene butadiene copolymers, acrylics, acrylates, polyvinyl ethers, polyvinyl acetate copolymers, polyisobutylenes, and mixtures, blends, and copolymers thereof. Acrylic-based formulations, however, generally are considered to be preferred for the EMI applications of the type herein involved. Although PSA's are preferred for adhesive layer 70, other adhesives such as epoxies and urethanes may be substituted and, accordingly, are to be considered within the scope of the present invention. Heat-fusible adhesives such a hot-melts and thermoplastic films additionally may find applicability.

Inasmuch as the bulk conductivity of gasket 50 is determined substantially through its surface contact with the substrate, an electrically-conductive PSA may be preferred to ensure optimal EMI shielding performance. Such adhesives conventionally are formulated as containing about 1-25% by weight of a conductive filler to yield a volume resistivity of from about 0.01-0.001 Ω-cm. The filler may be incorporated in the form of particles, fibers, flakes, microspheres, or microballoons, and may range in size of from about 1-100 microns. Typically filler materials include inherently conductive material such as metals, carbon, and graphite, or nonconductive materials such as plastic or glass having a plating of a conductive material such as a noble metal or the like. In this regard, the means by which the adhesive is rendered electrically conductive is not considered to be a critical aspect of the present invention, such that any means achieving the desired conductivity and adhesion are to be considered suitable.

For protecting the outer portion of adhesive layer 70 which is exposed on the exterior surface of the gasket, a release sheets, shown at 72, may be provided as removably attached to the exposed adhesive. As is common in the adhesive art, release sheet 72 may be provided as strip of a waxed, siliconized, or other coated paper or plastic sheet or the like having a relatively low surface energy so as to be removable without appreciable lifting of the adhesive from the exterior surface 64.

Gasket construction 50 advantageously provides a structure that may be used in very low closure force, i.e., less than about 1 lb/inch (0.175 N/mm), applications. In service, the bonding of the fabric 12 edges 55 effected by the use of the thermosetting film adhesive layer 14 has been observed to hold the seam 56 of the material 10 more securely to the core 52 to thereby increase the resistance of the gasket 50 to a common failure mode in flame testing, namely, the opening of the seam and the direct exposure of the core to the flame. The use of such layer 14 therefore facilitates the production of an EMI shielding fabric-over-foam gasket construction which is RoHS compliance and which exhibits a flame class rating of V-0 under UL94.

As it is anticipated that certain changes may be made in the present invention without departing from the precepts herein involved, it is intended that all matter contained in the foregoing description shall be interpreted as illustrative and not in a limiting sense. All references including any priority documents cited herein are expressly incorporated by reference.

## Claims

1. A flame retardant, electromagnetic interference (EMI) shielding gasket comprising:
a resilient core member (52) having an outer surface (54), the core member (52) being formed of an elastomeric polymeric material;
an electrically-conductive fabric member (12) surrounding the outer surface (54) of the core member (52), the fabric member (12), having an interior surface (18) disposed facing the outer surface (54), of the core member (52), and an oppositely-facing exterior surface (16), and the fabric member (12), having a first edge (55a) and a second edge (55b); and
a layer (14) of a cured, thermoset, flame retardant film adhesive interposed between the interior surface (18) of the fabric member (12) and the outer surface (54) of the core member (52), the gasket being **characterized in that:**
the second edge (55b) of the fabric member (12) adjoins the first edge (55a) to form a seam (56) therebetween, the seam (56) extending along at least a portion of the core member (52); and
the layer (14) bonds the first and second edges (55a, 55b) of the fabric member (12) to the core member (52) along at least a portion of the seam (56) effective to afford the gasket a flame class rating of V-0 under Underwriter's Laboratories (UL) Standard No. 94.

2. The gasket of claim 1 wherein the film adhesive layer has a thickness of between about 1-10 mils (25.4-254 µm).

3. The gasket of claim 1 wherein the film adhesive layer comprises a polyester or copolyester resin.

4. The gasket of claim 1 wherein the fabric member is a metal-plated cloth.

5. The gasket of claim 4 wherein the cloth comprises fibers selected from the group consisting of cotton, wool, silk, cellulose, polyester, polyamide, nylon, and combinations thereof, and the metal is selected from the group consisting of copper, nickel, silver, nickel-plated-silver, aluminum, tin, and combinations thereof.

6. The gasket of claim 1 wherein the elastomeric polymeric material is selected from the group consisting of polyethylenes, polypropylenes, polypropylene-EPDM blends, butadienes, styrene-butadienes, nitriles, chlorosulfonates, neoprenes, urethanes, silicones, polyolefin resin/monoolefin copolymer blends, and copolymers, blends, and combinations thereof.

7. The gasket of claim 6 wherein the elastomeric polymeric material is foamed.

8. The gasket of claim 1 wherein the fabric member has a thickness of between about 2-4 mils (50.8-101.6 µm).

9. The gasket of claim 1 wherein the film adhesive layer complies with European Union Directive 2002/95/EC, "Restriction on the Use of Certain Hazardous Substances (RoHS) in Electrical and Electronic Equipment."

10. The gasket of claim 1 wherein the film adhesive layer comprises an effective amount of one or more flame retardant additives.

11. The gasket of claim 10 wherein the one or more flame retardant additives is selected from the group consisting of aluminum hydrate, antimony trioxide, phosphate esters, and halogenated compounds.

12. A method of imparting flame retardancy to an electromagnetic interference (EMI) shielding gasket construction, the gasket comprising a resilient core member (52) having an outer surface (54) and being formed of an elastomeric polymeric material, and an electrically-conductive fabric member (12) surrounding the outer surface (54) of the core member (52), the fabric member (12) having an interior surface (18) disposed facing the outer surface (54) of the core member (52) and an oppositely-facing exterior surface (16), and the fabric member (12) having a first edge (55a) and a second edge (55b), the method comprising the step of:
interposing a layer (14) of a cured, thermoset, flame retardant film adhesive between the interior surface (18) of the fabric member (12) and the outer surface (54) of the core member (52), the method being **characterized in that**:
the a second edge (55b) of the fabric member (12) adjoins the first edge (55a) to form a seam (56) therebetween, the seam (56) extending along at least a portion of the core member (52); and
the adhesive layer (14) bonds the first and second edges (55a, 55b) of the fabric member to the core member along at least a portion of the seam.

13. The method of claim 12 wherein the gasket exhibits a flame class rating of V-0 under Underwriter's Laboratories (UL) Standard No. 94.

14. The method of claim 12 wherein the film adhesive layer has a thickness of between about 1-10 mils (25.4-254 µm).

15. The method of claim 12 wherein the film adhesive layer comprises a polyester or copolyester resin.

16. The method of claim 12 wherein the fabric member is a metal-plated cloth.

17. The method of claim 16 wherein the cloth comprises fibers selected from the group consisting of cotton, wool, silk, cellulose, polyester, polyamide, nylon, and combinations thereof, and the metal is selected from the group consisting of copper, nickel, silver, nickel-plated-silver, aluminum, tin, and combinations thereof.

18. The method of claim 12 wherein the elastomeric polymeric material is selected from the group consisting of polyethylenes, polypropylenes, polypropylene-EPDM blends, butadienes, styrene-butadienes, nitriles, chlorosulfonates, neoprenes, urethanes, silicones, polyolefin resin/monoolefin copolymer blends, and copolymers, blends, and combinations thereof.

19. The method of claim 18 wherein the elastomeric polymeric material is foamed.

20. The method of claim 12 wherein the fabric member has a thickness of between about 2-4 mils (50.8-101.6 µm).

21. The method of claim 12 wherein the film adhesive layer complies with European Union Directive 2002/95/EC, "Restriction on the Use of Certain Hazardous Substances (RoHS) in Electrical and Electronic Equipment."

22. The method of claim 12 wherein the film adhesive layer comprises an effective amount of one or more flame retardant additives.

23. The method of claim 22 wherein the one or more flame retardant additives is selected from the group consisting of aluminum hydrate, antimony trioxide, phosphate esters, and halogenated compounds.

## Patentansprüche

1. Flammhemmende Abschirmdichtung gegen elektromagnetische Beeinflussung (EMI), mit:
einem elastischen Kern (52), der eine äußere Oberfläche (54) hat und aus einem elastomeren Polymermaterial gebildet ist;
einem elektrisch leitenden Materialstrukturteil (12), welches die äußere Oberfläche (54) des Kerns (52) umgibt und eine innere Oberfläche (18), welche der äußeren Oberfläche (54) des Kerns (52) zugewandt angeordnet ist, und eine entgegengesetzt zugewandte äußere Oberfläche (16) und eine erste Kante (55a) sowie eine zweite Kante (55b) hat; und
einer Schicht (14) eines gehärteten, thermogehärteten, flammhemmenden Filmklebstoffes, der zwischen der inneren Oberfläche (18) des Materialstrukturteils (12) und der äußeren Oberfläche (54) des Kerns (52) angeordnet ist, wobei die Dichtung **dadurch gekennzeichnet, daß:**
die zweite Kante (55b) des Materialstrukturteils (12) an die erste Kante (55a) angrenzt, um dazwischen eine Naht (56) zu bilden, wobei sich die Naht (56) längs mindestens eines Abschnittes des Kerns (52) erstreckt; und
die Schicht (14) die erste und zweite Kante (55a, 55b) des Materialstrukturteils (12) an den Kern (52) längs mindestens eines Abschnittes der Naht (56) bindet mit der Wirkung, der Dichtung eine Flammklassenbewertung von V-0 gemäß der Normnummer 94 der Underwriter's Laboratories (UL) zu gewähren.

2. Dichtung nach Anspruch 1, wobei die Filmklebeschicht eine Dicke von zwischen etwa 1 - 10 mils (25,4 - 254 µm) hat.

3. Dichtung nach Anspruch 1, wobei die Filmklebeschicht ein Polyester- oder Copolyesterharz aufweist.

4. Dichtung nach Anspruch 1, wobei das Materialstrukturteil ein metallplattiertes Tuch ist.

5. Dichtung nach Anspruch 4, wobei das Tuch Fasern aufweist, die aus der Gruppe ausgewählt sind, welche aus Baumwolle, Wolle, Seide, Zellulose, Polyester, Polyamid, Nylon und Kombinationen von diesen besteht und das Metall aus der Gruppe ausgewählt ist, welche aus Kupfer, Nickel, Silber, nickelplattiertes Silber, Aluminium, Zinn und Kombinationen von diesen besteht.

6. Dichtung nach Anspruch 1, wobei das elastomere Polymermaterial aus der Gruppe ausgewählt ist, die aus Polyethylenen, Polypropylenen, Polypropylen-EPDM-Gemischen, Butadienen, Styren-Butadienen, Nitrilen, Chlorsulfonaten, Neoprenen, Urethanen, Silikonen, Polyolefinharz-/Monoolefin-Copolymergemischen und Copolymeren, Gemischen und Kombinationen von diesen besteht.

7. Dichtung nach Anspruch 6, wobei das elastomere Polymermaterial geschäumt ist.

8. Dichtung nach Anspruch 1, wobei das Materialstrukturteil eine Dicke von zwischen etwa 2 - 4 mils (50,8 - 101,6 µm) hat.

9. Dichtung nach Anspruch 1, wobei die Filmklebeschicht die Richtlinie 2002/95/EC der Europäischen Union erfüllt "Restriction on the Use of Certain Hazardous Substances (RoHS) in Electrical and Electronic Equipment" ("Beschränkung bei der Benutzung von gewissen gefährlichen Substanzen (RoHS) in elektrischen und elektronischen Geräten").

10. Dichtung nach Anspruch 1, wobei die Filmklebeschicht eine wirksame Menge von einem oder mehreren flammhemmenden Additiven aufweist.

11. Dichtung nach Anspruch 10, wobei eines oder mehrere flammhemmende Additive ausgewählt ist oder sind aus der Gruppe, die aus Aluminiumhydrat, Antimontrioxid, Phosphatester und halogenierten Verbindungen besteht.

12. Verfahren zum Verleihen einer Flammhemmung an eine Abschirmdichtungskonstruktion gegen elektromagnetische Beeinflussung (EMI), wobei die Dichtung einen elastischen Kern (52), der eine äußere Oberfläche (54) hat und aus einem elastomeren Polymermaterial gebildet ist, und ein elektrisch leitendes Materialstrukturteil (12) aufweist, welches die äußere Oberfläche (54) des Kerns (52) umgibt, wobei das Materialstrukturteil (12) eine innere Oberfläche (18) hat, welche der äußeren Oberfläche (54) des Kerns (52) zugewandt angeordnet ist, und eine entgegengesetzt zugewandte äußere Oberfläche (16) hat, wobei das Materialstrukturteil (12) eine erste Kante (55a) und eine zweite Kante (55b) hat und das Verfahren den Schritt aufweist:
des Anordnens einer Schicht (14) aus einem gehärteten, thermogehärteten, flammhemmenden Filmklebstoff zwischen der inneren Oberfläche (18) des Materialstrukturteils (12) und der äußeren Oberfläche (54) des Kerns (52), wobei das Verfahren **dadurch gekennzeichnet ist, daß**:
die zweite Kante (55b) des Materialstrukturteils (12) an die erste Kante (55a) zur Bildung einer Naht (56) dazwischen angrenzt, die Naht (56) sich längs mindestens eines Abschnittes des Kerns (52) erstreckt; und daß
die Klebstoffschicht (14) die ersten und zweiten Kanten (55a, 55b) des Materialstrukturteils an den Kern längs mindestens eines Abschnittes der Naht bindet.

13. Verfahren nach Anspruch 12, wobei die Dichtung eine Flammklassenbeurteilung von V-0 gemäß der Norm Nummer 94 der Underwriter's Laboratories (UL) aufweist.

14. Verfahren nach Anspruch 12, wobei die Filmklebeschicht eine Dicke von zwischen etwa 1 - 10 mils (25,4 - 254 µm) hat.

15. Verfahren nach Anspruch 12, wobei die Filmklebeschicht ein Polyester- oder Copolyesterharz aufweist.

16. Verfahren nach Anspruch 12, wobei das Materialstrukturteil ein metallplattiertes Tuch ist.

17. Verfahren nach Anspruch 16, wobei das Tuch Fasern aufweist, die aus der Gruppe ausgewählt sind, welche aus Baumwolle, Wolle, Seide, Zellulose, Polyester, Polyamid, Nylon und Kombinationen von diesen besteht, und das Metall aus der Gruppe ausgewählt ist, welche aus Kupfer, Nickel, Silber, nickelplattiertes Silber, Aluminium, Zinn und Kombinationen von diesen besteht.

18. Verfahren nach Anspruch 12, wobei das elastomere Polymermaterial aus der Gruppe ausgewählt ist, die aus Polyethylenen, Polypropylenen, Polypropylen-EPDM-Gemischen, Butadienen, Styren-Butadienen, Nitrilen, Chlorsulfonaten, Neoprenen, Urethanen, Silikonen, Polyolefinharz-/Monoolefin-Copolymergemischen und Copolymeren, Gemischen und Kombinationen von diesen besteht.

19. Verfahren nach Anspruch 18, wobei das elastomere Polymermaterial geschäumt ist.

20. Verfahren nach Anspruch 12, wobei das Materialstrukturteil eine Dicke von zwischen etwa 2 - 4 mils (50,8 - 101,6 µm) hat.

21. Verfahren nach Anspruch 12, wobei die Filmklebeschicht die Richtlinie 2002/95/EC der Europäischen Union erfüllt "Restriction on the Use of Certain Hazardous Substances (RoHS) in Electrical and Electronic Equipment" ("Beschränkung bei der Benutzung von gewissen gefährlichen Substanzen (RoHS) in elektrischen und elektronischen Geräten").

22. Verfahren nach Anspruch 12, wobei die Filmklebeschicht eine wirksame Menge von einem oder mehreren flammhemmenden Additiven aufweist.

23. Verfahren nach Anspruch 22, wobei eines oder die mehreren flammhemmenden Additive ausgewählt ist oder sind aus der Gruppe, die aus Aluminiumhydrat, Antimontrioxid, Phosphatester und halogenierten Verbindungen besteht.

## Revendications

1. Joint de protection contre les interférences électromagnétiques (EMI), par blindage à retardement de flamme, comprenant :
un élément élastique formant partie centrale (52) présentant une surface extérieure (54), l'élément formant partie centrale (52) étant fait en une matière polymère élastomère ;
un élément en tissu électriquement conducteur (12) entourant la surface extérieure (54) de l'élément formant partie centrale (52), l'élément en tissu (12) ayant une surface intérieure (18) disposée en face de la surface extérieure (54) de l'élément formant partie centrale (52), et une surface extérieure (16) dirigée à l'opposé ; et l'élément en tissu (12) présentant un premier bord (55a) et un second bord (55b) ; et
une couche (14) d'une pellicule adhésive polymérisée, thermodurcie et retardatrice de flamme, intercalée entre la surface intérieure (18) de l'élément en tissu (12) et la surface extérieure (54) de l'élément formant partie centrale (52), le joint étant **caractérisé en ce que :**
le second bord (55b) de l'élément en tissu (12) est adjacent au premier bord (55a) de façon à former une jonction continue (56) entre eux, cette jonction continue (56) s'étendant le long d'au moins une partie de l'élément formant partie centrale (52) ; et
la couche (14) fixe les premier et second bords (55a, 55b) de l'élément en tissu (12) à l'élément formant partie centrale (52) le long d'au moins une partie de la jonction continue (56) avec pour effet d'assurer au joint un classement pare-flamme de V - 0 suivant la norme UL (Underwriter's (assureur maritime) Laboratories) n° 94.

2. Joint selon la revendication 1, dans lequel la couche de pellicule adhésive présente une épaisseur comprise entre environ 1 et 10 mils (entre 25,4 et 254 µm).

3. Joint selon la revendication 1, dans lequel la couche de pellicule adhésive comprend une résine de polyester ou de copolyester.

4. Joint selon la revendication 1, dans lequel l'élément en tissu est une toile à revêtement métallique.

5. Joint selon la revendication 4, dans lequel la toile comprend des fibres sélectionnées à partir du groupe composé du coton, de la laine, de la soie, de la cellulose, du polyester, du polyamide, du nylon, et de combinaisons de ceux-ci, et le métal est sélectionné à partir du groupe composé du cuivre, du nickel, de l'argent, de l'argent nickelé, de l'aluminium, de l'étain et de combinaisons de ceux-ci.

6. Joint selon la revendication 1, dans lequel la matière polymère élastomère est sélectionnée à partir du groupe composé de polyéthylènes, de polypropylènes, de mélanges polypropylène-EPDM, de butadiènes, de styrène-butadiènes, de nitriles, de chlorosulfonates, de néoprènes, d'uréthannes, de silicones, de mélanges résine de polyoléfine / copolymère mono-oléfinique, et de copolymères, mélanges et combinaisons de ceux-ci.

7. Joint selon la revendication 6, dans lequel la matière polymère élastomère est sous forme de mousse.

8. Joint selon la revendication 1, dans lequel l'élément en tissu présente une épaisseur comprise entre environ 2 et 4 mils (entre 50,8 et 101,6 µm).

9. Joint selon la revendication 1, dans lequel la couche de pellicule adhésive satisfait à la Directive de l'union Européenne 2002/95/EC intitulée "Restriction on the Use of Certain Hazardous Substances (RoHS) in Electrical and Electronic Equipment *(Restrictions quant* à *l'utilisation de certaines substances dangereuses dans le matériel électrique et électronique)*".

10. Joint selon la revendication 1, dans lequel la couche de pellicule adhésive contient une quantité efficace d'un ou de plusieurs additif(s) retardateur(s) de flamme.

11. Joint selon la revendication 10, dans lequel le ou les additif (s) retardateur(s) de flamme est ou sont sélectionné(s) à partir du groupe comprenant l'hydrate d'aluminium, le trioxyde d'antimoine, les esters phosphoriques, et des composés halogénés.

12. Procédé de communication d'une propriété de retardement de flamme à une structure formant joint de protection contre les interférences électromagnétiques (EMI), le joint comprenant un élément élastique formant partie centrale (52) présentant une surface extérieure (54) et fait en une matière polymère élastomère ; et un élément en tissu électriquement conducteur (12) entourant la surface extérieure (54) de l'élément formant partie centrale (52), l'élément en tissu (12) ayant une surface intérieure (18) disposée en face de la surface extérieure (54) de l'élément formant partie centrale (52), et une surface extérieure (16) dirigée à l'opposé, et l'élément en tissu (12) présentant un premier bord (55a) et un second bord (55b), le procédé comprenant l'étape de :
intercalation d'une couche (14) d'une pellicule adhésive polymérisée, thermodurcie et retardatrice de flamme, entre la surface intérieure (18) de l'élément en tissu (12) et la surface extérieure (54) de l'élément formant partie centrale (52), le procédé étant **caractérisé en ce que** :
le second bord (55b) de l'élément en tissu (12) est adjacent au premier bord (55a) de façon à former une jonction continue (56) entre eux, cette jonction continue (56) s'étendant le long d'au moins une partie de l'élément formant partie centrale (52) ; et
la couche (14) fixe les premier et second bords (55a, 55b) de l'élément en tissu à l'élément formant partie centrale le long d'au moins une partie de la jonction continue.

13. Procédé selon la revendication 12, dans lequel le joint présente un classement pare-flamme de V - 0 suivant la norme UL (Underwriter's Laboratories) n° 94.

14. Procédé selon la revendication 12, dans lequel la couche de pellicule adhésive présente une épaisseur comprise entre environ 1 et 10 mils (entre 25,4 et 254 µm).

15. Procédé selon la revendication 12, dans lequel la couche de pellicule adhésive comprend une résine de polyester ou de copolyester.

16. Procédé selon la revendication 12, dans lequel l'élément en tissu est une toile à revêtement métallique.

17. Procédé selon la revendication 16, dans lequel la toile comprend des fibres sélectionnées à partir du groupe composé du coton, de la laine, de la soie, de la cellulose, du polyester, du polyamide, du nylon, et de combinaisons de ceux-ci, et le métal est sélectionné à partir du groupe composé du cuivre, du nickel, de l'argent, de l'argent nickelé, de l'aluminium, de l'étain et de combinaisons de ceux-ci.

18. Procédé selon la revendication 12, dans lequel la matière polymère élastomère est sélectionnée à partir du groupe composé de polyéthylènes, de polypropylènes, de mélanges polypropylène-EPDM, de butadiènes, de styrène-butadiènes, de nitriles, de chlorosulfonates, de néoprènes, d'uréthannes, de silicones, de mélanges résine de polyoléfine / copolymère mono-oléfinique, et de copolymères, mélanges et combinaisons de ceux-ci.

19. Procédé selon la revendication 18, dans lequel la matière polymère élastomère est sous forme de mousse.

20. Procédé selon la revendication 12, dans lequel l'élément en tissu présente une épaisseur comprise entre environ 2 et 4 mils (entre 50,8 et 101,6 µm).

21. Joint selon la revendication 12, dans lequel la couche de pellicule adhésive satisfait à la Directive de l'Union Européenne 2002/95/EC intitulée "Restriction on the Use of Certain Hazardous Substances (RoHS) in Electrical and Electronic Equipment *(Restrictions quant à l'utilisation de certaines substances dangereuses dans le matériel électrique et électronique)*".

22. Procédé selon la revendication 12, dans lequel la couche de pellicule adhésive contient une quantité efficace d'un ou de plusieurs additif(s) retardateur(s) de flamme.

23. Procédé selon la revendication 22, dans lequel le ou les additif(s) retardateur(s) de flamme est ou sont sélectionné(s) à partir du groupe comprenant l'hydrate d'aluminium, le trioxyde d'antimoine, les esters phosphoriques, et des composés halogénés.
